# DEMANDE DE BREVET EUROPEEN

(11) **EP 3 357 755 A1**
(43) Date de publication de la demande: **08.08.2018**
(21) Numéro de dépôt: 18154975.9
(22) Date de dépôt: 02.02.2018
(51) Int. Cl.: B60Q 3/82, B60Q 3/85, B60Q 3/76, B60H 1/00, B60K 37/06, B60Q 3/18, G06F 3/01, G06F 3/044, F21V 23/04, B60Q 3/74, H03K 17/96, B60K 37/00

(54) **DISPOSITIF D'ECLAIRAGE INTERIEUR D'UN VEHICULE**

(30) Priorité: 02.02.2017 FR 1750877
(71) Demandeur: Eolane Combree, 49520 Combree (FR)
(72) Inventeur: RIOTEAU, Matthieu, 49520 Combree (FR); SELLIN, Yann, 49000 Angers (FR)
(74) Mandataire: Cabinet Le Guen Maillet

(57) **Abrégé**

La présente invention concerne un procédé et un dispositif d'éclairage intérieur d'un véhicule constitué d'un boîtier (100) au moins en partie transparent ou translucide dont une des faces transparente ou translucide est un collimateur (130) pour l'énergie lumineuse générée par au moins une diode électroluminescente (100), caractérisé en ce que un premier et un second capteurs capacitifs (120a, 120b) sont placés en regard de ladite face collimatrice, la au moins une diode électroluminescente est placée en regard avec ladite face collimatrice, les capteurs capacitifs sont placés de part et d'autre de la au moins une diode électroluminescente selon une première direction, le dispositif d'éclairage comporte un circuit imprimé (170) comportant un module de traitement (190) qui commande le passage ou non d'un courant dans la au moins une diode électroluminescente si les signaux électriques obtenus du premier et du second capteurs capacitifs sont dans une plage de valeur prédéterminée.

## Description

La présente invention concerne un dispositif d'éclairage intérieur d'un véhicule.

Les véhicules, tels que par exemple les véhicules automobiles, disposent d'au moins un plafonnier, d'une ou plusieurs lampes de lecture.

La localisation de l'organe de commande de ces dispositifs d'éclairage est parfois difficile à identifier lorsque les conditions de luminosité ambiante extérieures sont très faibles. Le fait que le conducteur du véhicule doit chercher l'organe de commande peut parfois perturber sa concentration dans la conduite du véhicule.

Les passagers occasionnels du véhicule sont confrontés aussi au problème de localisation de l'organe de commande.

Ceci rend l'utilisation des plafonniers ou des lampes de lecture peu pratique. La présente invention a pour but de résoudre les inconvénients de l'art antérieur en proposant un dispositif d'éclairage intérieur d'un véhicule qui soit intuitif et pratique dans son utilisation.

A cette fin, selon un premier aspect, l'invention propose un dispositif d'éclairage intérieur d'un véhicule constitué d'un boîtier au moins en partie transparent ou translucide dont une des faces transparente ou translucide est un collimateur pour l'énergie lumineuse générée par au moins une diode électroluminescente, caractérisé en ce que un premier et un second capteurs capacitifs sont placés en regard de ladite face collimatrice, la au moins une diode électroluminescente est disposée en regard avec ladite face collimatrice, les capteurs capacitifs sont placés de part et d'autre de la au moins une diode électroluminescente selon une première direction, le dispositif d'éclairage comporte un circuit imprimé comportant un module de traitement qui commande le passage ou non d'un courant dans la au moins une diode électroluminescente si les signaux électriques obtenus du premier et du second capteurs capacitifs sont dans une plage de valeur prédéterminée.

L'invention concerne aussi un procédé de commande d'un dispositif d'éclairage intérieur d'un véhicule constitué d'un boîtier au moins en partie transparent ou translucide dont une des faces transparente ou translucide est un collimateur pour l'énergie lumineuse générée par au moins une diode électroluminescente, caractérisé en ce que un premier et un second capteurs capacitifs sont placés en regard de ladite face collimatrice, la au moins une diode électroluminescente est disposée en regard avec ladite face collimatrice, les capteurs capacitifs sont placés de part et d'autre de la au moins une diode électroluminescente selon une première direction, le dispositif comporte un circuit imprimé comportant un module de traitement, caractérisé en ce que le procédé comporte les étapes de :
- obtention des signaux électriques du premier et du second capteurs capacitifs,
- commande du passage ou non d'un courant dans la au moins une diode électroluminescente si les signaux électriques obtenus du premier et du second capteurs capacitifs sont dans une plage de valeur prédéterminée.

Ainsi, l'organe de commande du dispositif d'éclairage est facilement localisable. Le dispositif d'éclairage étant transparent, un conducteur ou un passager localise facilement celui-ci et commande le dispositif d'éclairage simplement en appuyant sur la face collimatrice.

Un appui sur la partie du dispositif d'éclairage faisant office de collimateur, génère un comportement similaire des deux capteurs capacitifs placés de part et d'autre de la au moins une diode électroluminescente.

Des capteurs capacitifs constitués de matériaux ne laissant pas passer la lumière peuvent ainsi être utilisés.

Selon un mode particulier de l'invention, si au moins un des signaux électriques obtenus du premier et du second capteurs capacitifs n'est pas dans la plage de valeur prédéterminée, le module de traitement augmente ou réduit le courant dans la au moins une diode électroluminescente.

Ainsi, si le conducteur ou le passager appuie sur l'un ou l'autre des capteurs capacitifs, l'intensité lumineuse peut être modulée.

Selon un mode particulier de l'invention, le module de traitement augmente ou réduit le courant dans la au moins une diode électroluminescente en fonction de l'évolution dans le temps des signaux obtenus des deux capteurs capacitifs placés de part et d'autre de la au moins une diode électroluminescente selon la première direction.

Ainsi, la présente invention est ergonomique et est adaptée aux techniques de commande par balayage par un doigt d'une surface, qui sont appréciées par les utilisateurs de téléphones mobile intelligent ou de tablettes tactiles.

Selon un mode particulier de l'invention, le dispositif d'éclairage comporte un troisième et un quatrième capteurs capacitifs placés de part et d'autre de la au moins une diode électroluminescente selon une seconde direction perpendiculaire à la première direction, et le module de traitement augmente ou réduit le courant dans la au moins une diode électroluminescente en fonction de l'évolution dans le temps des signaux obtenus d'au moins trois capteurs capacitifs.

Ainsi, la présente invention est ergonomique et est adaptée aux techniques de commande par balayage par un doigt d'une surface, qui sont appréciées par les utilisateurs de téléphones mobile intelligent ou de tablettes tactiles.

Selon un mode particulier de l'invention, le module de traitement commande un premier autre dispositif différent du dispositif d'éclairage intérieur en fonction de l'évolution dans le temps des signaux obtenus des deux capteurs capacitifs placés de part et d'autre de la au moins une diode électroluminescente selon la seconde direction.

Ainsi, la présente invention permet de regrouper les organes de commande de différents dispositifs en un unique point et simplifie de la sorte l'ergonomie et le câblage électrique du véhicule.

Selon un mode particulier de l'invention, le module de traitement commande un second autre dispositif différent du dispositif d'éclairage intérieur et du premier autre dispositif en fonction de l'évolution dans le temps des signaux obtenus d'au moins trois capteurs capacitifs.

Ainsi, la présente invention est ergonomique et est adaptée aux techniques de commande par balayage en rotation d'un doigt, qui sont intuitives pour le conducteur ou le passager.

L'invention permet ainsi de contrôler trois dispositifs différents.

Selon un mode particulier de l'invention, le premier autre dispositif est un dispositif de régulation de température et le second autre dispositif est un dispositif de ventilation.

Selon un mode particulier de l'invention, une pluralité d'autres diodes électroluminescentes est placée en périphérie du circuit imprimé et le boîtier comporte des réflecteurs optiques pour réfléchir l'énergie lumineuse générée par les autres diodes électroluminescentes dans la même direction que la au moins une diode électroluminescente.

Ainsi, le dispositif d'éclairage est facilement localisable, même dans l'obscurité.

Selon un mode particulier de l'invention, le module de traitement commande le passage ou non d'un courant dans au moins une diode de la pluralité d'autre diodes en fonction de l'évolution dans le temps des signaux obtenus d'au moins trois capteurs capacitifs ou de deux capteurs capacitifs placés de part et d'autre de la au moins une diode électroluminescente selon la même direction.

Ainsi, le conducteur ou les passagers peuvent recevoir une information visuelle représentative du réglage qu'ils ont effectué et de la plage de réglage.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente une coupe d'un dispositif d'éclairage intérieur d'un véhicule selon la présente invention ;
la Fig. 2 représente une vue du dispositif d'éclairage intérieur d'un véhicule selon la présente invention ;
la Fig. 3 représente un premier mode de réalisation du dispositif d'éclairage selon la présente invention ;
la Fig. 4 représente un second mode de réalisation du dispositif d'éclairage selon la présente invention ;
la Fig. 5 représente un troisième mode de réalisation du dispositif d'éclairage selon la présente invention ;
la Fig. 6 représente un quatrième mode de réalisation du dispositif d'éclairage selon la présente invention ;
la Fig. 7 représente un cinquième mode de réalisation du dispositif d'éclairage selon la présente invention ;
la Fig. 8 représente un exemple d'architecture du module de traitement selon la présente invention;
la Fig. 9 représente un exemple d'algorithme exécuté par le module de traitement selon la présente invention.

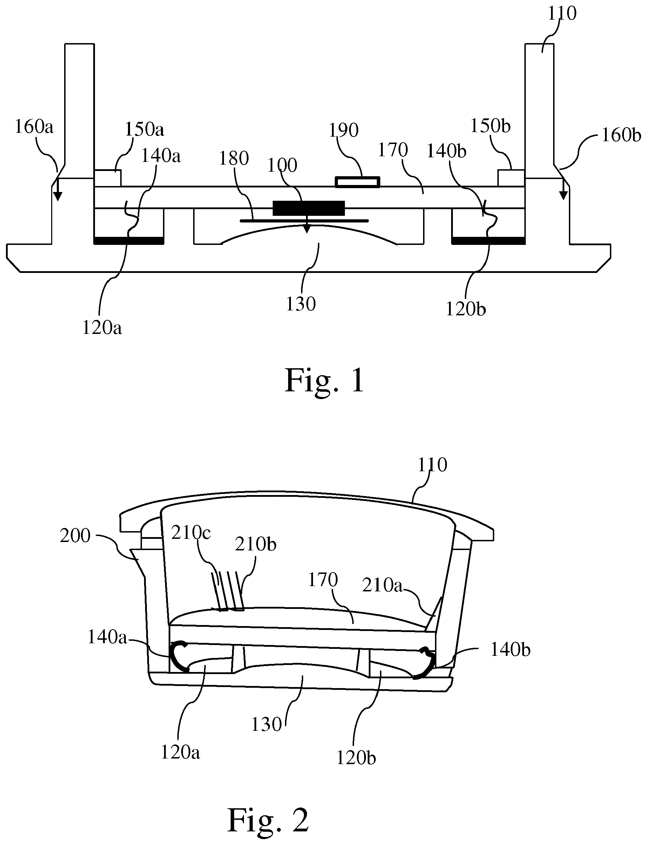

La **Fig. 1** représente une coupe d'un dispositif d'éclairage intérieur d'un véhicule selon la présente invention.

Le dispositif d'éclairage intérieur d'un véhicule est constitué d'un boîtier 110 au moins en partie transparent ou translucide dont une des faces transparente ou translucide est un collimateur 130 pour l'énergie lumineuse générée par au moins une diode électroluminescente 100.

Le boîtier 110 est transparent sur la face collimatrice 130. Dans un mode particulier de réalisation de la présente invention, le boîtier est réalisé en une seule pièce transparente ou translucide.

Le boîtier 100 comporte deux ou quatre capteurs capacitifs 120a et 120b placés en regard de la face collimatrice 130, préférentiellement en contact avec la face collimatrice 130. La au moins une diode électroluminescente 100 est disposée sur une face d'un circuit imprimé 170 et en regard avec la face collimatrice 130. Les capteurs capacitifs 120a et 120b sont placés de part et d'autre de la diode électroluminescente 100 selon une première direction. Le circuit imprimé 170 comporte un module de traitement 190 qui commande le passage ou non d'un courant dans la diode électroluminescente si les signaux électriques obtenus du premier et du second capteurs capacitifs sont dans une plage de valeur prédéterminée.

Les capteurs capacitifs 120a et 120b ont une fonction ressort 140a et 140b et sont par exemple réalisés en métal embouti.

Dans un mode particulier de réalisation, une pluralité d'autres diodes électroluminescentes 150a et 150b est placée en périphérie du circuit imprimé 170, par exemple sur la face qui n'est pas en regard avec la face collimatrice et le boîtier 110 comporte des réflecteurs optiques 160a et 160b pour réfléchir l'énergie lumineuse générée par les autres diodes électroluminescentes dans la même direction que la diode électroluminescente 100.

Dans une variante de réalisation, un écran diffusant 180 contrôlé par le module de traitement est placé entre la diode électroluminescente et la face collimatrice pour obtenir un faisceau de lumière concentré ou un faisceau de lumière diffus.

La **Fig. 2** représente une vue du dispositif d'éclairage intérieur d'un véhicule selon la présente invention.

Le boîtier 110 comporte des clips de maintien 200 pour insérer le dispositif d'éclairage dans l'habitacle du véhicule.

Le boîtier 110 comporte des clips de maintien 210a, 210b et 210c du circuit imprimé 170.

Les capteurs capacitifs 120a et 120b sont préférentiellement plaqués contre la paroi du boîtier 110 formant ainsi une capacité créée par un empilage capteur paroi et doigt. La présence d'air, dont la permittivité est variable selon l'humidité, est ainsi évitée et rend la présente invention insensible aux éventuelles variations climatiques.

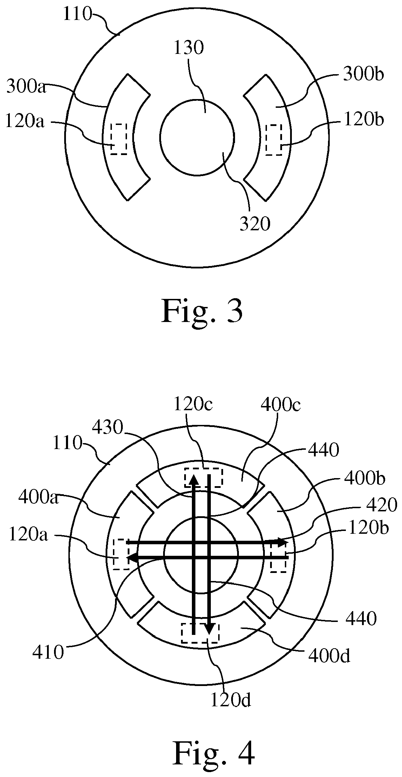

La **Fig. 3** représente un premier mode de réalisation du dispositif d'éclairage selon la présente invention.

Dans l'exemple de la Fig. 3, le dispositif d'éclairage comporte deux capteurs capacitifs 120a et 120b placés de part et d'autre de la diode électroluminescente 100 selon une première direction.

Des pictogrammes sont représentés dans les zones 300a et 300b et placés au dessus des capteurs capacitifs 120a et 120b pour guider le conducteur ou le passager dans le pilotage du dispositif d'éclairage.

Par exemple, un appui sur la zone 300a est détecté par le module électronique de détermination de commande et d'application de commande 190 qui diminue le courant dans la diode électroluminescente 100. Le module électronique de détermination de commande 190 détecte ainsi que les signaux électriques obtenus du premier et du second capteurs capacitifs 120a et 120b ne sont pas dans la plage de valeur prédéterminée.

Par exemple, un appui sur la zone 300b est détecté par le module de traitement 190 qui augmente le courant dans la diode électroluminescente 100. Le module de traitement 190 détecte ainsi que les signaux électriques obtenus du premier et du second capteurs capacitifs 120a et 120b ne sont pas dans la plage de valeur prédéterminée.

Par exemple, un appui sur la zone 320, c'est-à-dire la zone du collimateur 130, est détecté par le module de traitement 190 qui commande le passage ou non d'un courant dans la au moins une diode électroluminescente 100 car les signaux électriques obtenus du premier et du second capteurs capacitifs sont dans une plage de valeur prédéterminée par exemple comprise entre 40 et 60% du signal provoqué par un appui sur un unique capteur capacitif 120a ou 120b.

La **Fig. 4** représente un second mode de réalisation du dispositif d'éclairage selon la présente invention.

Dans l'exemple de la Fig. 4, le dispositif d'éclairage comporte quatre capteurs capacitifs 120a, 120b, 120c et 120d. Les capteurs capacitifs 120a et 120b sont placés de part et d'autre de la diode électroluminescente 100 selon une première direction. Les capteurs capacitifs 120c et 120d sont placés de part et d'autre de la diode électroluminescente 100 selon une seconde direction orthogonale à la première direction.

Des pictogrammes sont représentés dans les zones 400a, 400b, 400c et 400d et placés au dessus des capteurs capacitifs 120a à 120d pour guider le conducteur ou le passager dans la commande du dispositif d'éclairage.

Les capteurs 120a et 120b permettent de faire varier l'éclairage du dispositif d'éclairage et les capteurs 120c et 120d permettent de commander un autre dispositif, par exemple un dispositif de régulation de la température ou un dispositif de ventilation.

Par exemple, le module de traitement 190 augmente le courant dans la diode électroluminescente en fonction de l'évolution dans le temps des signaux obtenus des deux capteurs capacitifs 120a et 120b lorsque le conducteur ou le passager balaie les zones 400a ou 400b selon le sens de la flèche 420.

Par exemple, le module de traitement 190 réduit le courant dans la diode électroluminescente en fonction de l'évolution dans le temps des signaux obtenus des deux capteurs capacitifs 120a et 120b lorsque le conducteur ou le passager balaie les zones 400a ou 400b selon le sens de la flèche 410.

Par exemple, le module de traitement 190 augmente la température ou augmente la ventilation en fonction de l'évolution dans le temps des signaux obtenus des deux capteurs capacitifs 120c et 120d lorsque le conducteur ou le passager balaie les zones 400c et 400d selon le sens de la flèche 430.

Par exemple, le module de traitement 190 réduit la température ou réduit la ventilation en fonction de l'évolution dans le temps des signaux obtenus des deux capteurs capacitifs 120c et 120d lorsque le conducteur ou le passager balaie les zones 400c et 400d selon le sens de la flèche 440.

Par exemple, un appui au milieu des capteurs capacitifs 120a à 120d est détecté par le module de traitement 190 qui commande le passage ou non d'un courant dans la diode électroluminescente 100 car les signaux électriques obtenus des capteurs capacitifs sont dans une plage de valeur prédéterminée par exemple comprise entre 20 et 30% du signal provoqué par un appui sur un unique capteur capacitif 120a ou 120b ou 120c ou 120d.

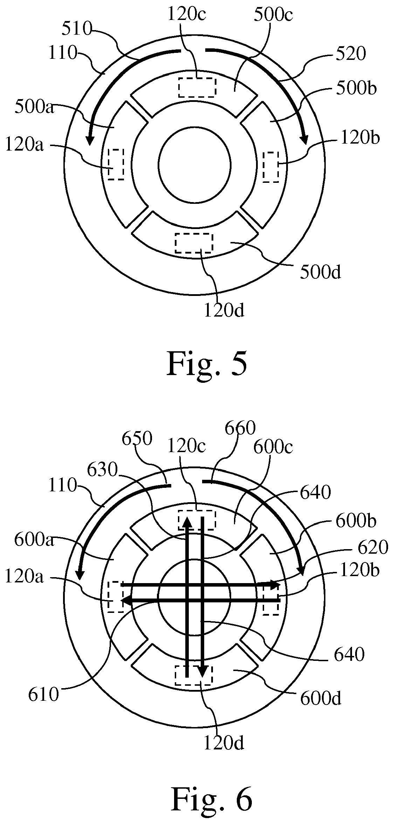

La **Fig. 5** représente un troisième mode de réalisation du dispositif d'éclairage selon la présente invention.

Dans l'exemple de la Fig. 5, le dispositif d'éclairage comporte quatre capteurs capacitifs 120a, 120b, 120c et 120d. Les capteurs capacitifs 120a et 120b sont placés de part et d'autre de la diode électroluminescente 100 selon une première direction. Les capteurs capacitifs 120c et 120d sont placés de part et d'autre de la diode électroluminescente 100 selon une seconde direction orthogonale à la première direction.

Des pictogrammes sont représentés dans les zones 500a, 500b, 500c et 500d et placés au dessus des capteurs capacitifs 120a à 120d pour guider le conducteur ou le passager dans la commande du dispositif d'éclairage.

Les capteurs capacitifs 120a à 120d permettent de faire varier l'éclairage du dispositif d'éclairage.

Par exemple, le module de traitement 190 réduit le courant dans la diode électroluminescente 100 en fonction de l'évolution dans le temps des signaux obtenus des trois capteurs capacitifs 120c, 120a et 120d lorsque le conducteur ou le passager balaie les zones 500c, 500a et 500d selon le sens de la flèche 510.

Par exemple, le module de traitement 190 augmente le courant dans la diode électroluminescente en fonction de l'évolution dans le temps des signaux obtenus des trois capteurs capacitifs 120c, 120b et 120d lorsque le conducteur ou le passager balaie les zones 500c, 500b et 500d selon le sens de la flèche 520.

Par exemple, un appui au milieu des capteurs capacitifs 120a à 120d est détecté par le module de traitement qui commande le passage ou non d'un courant dans la diode électroluminescente 100 car les signaux électriques obtenus des capteurs capacitifs sont dans une plage de valeur prédéterminée par exemple comprise entre 20 et 30% du signal provoqué par un appui sur un unique capteur capacitif 120a ou 120b ou 120c ou 120d.

La **Fig. 6** représente un quatrième mode de réalisation du dispositif d'éclairage selon la présente invention.

Dans l'exemple de la Fig. 6, le dispositif d'éclairage comporte quatre capteurs capacitifs 120a, 120b, 120c et 120d. Les capteurs capacitifs 120a et 120b sont placés de part et d'autre de la diode électroluminescente 100 selon une première direction. Les capteurs capacitifs 120c et 120d sont placés de part et d'autre de la diode électroluminescente 100 selon une seconde direction orthogonale à la première direction.

Des pictogrammes sont représentés dans les zones 600a, 600b, 600c et 600d et placés au-dessus des capteurs capacitifs 120a à 120d pour guider le conducteur ou le passager dans la commande du dispositif d'éclairage.

Les capteurs 120a et 120b permettent de faire varier l'éclairage du dispositif d'éclairage, les capteurs 120c et 120d permettent de commander un premier autre dispositif, par exemple un dispositif de régulation de la température ou l'écran diffusant 180 et les capteurs 120a à 120d permettent de commander un second autre dispositif, par exemple un dispositif de ventilation.

Par exemple, le module de traitement 190 augmente le courant dans la diode électroluminescente en fonction de l'évolution dans le temps des signaux obtenus des deux capteurs capacitifs 120a et 120b lorsque le conducteur ou le passager balaie les zones 600a et 600b selon le sens de la flèche 620.

Par exemple, le module de traitement 190 réduit le courant dans la diode électroluminescente en fonction de l'évolution dans le temps des signaux obtenus des deux capteurs capacitifs 120a et 120b lorsque le conducteur ou le passager balaie les zones 600a et 600b selon le sens de la flèche 610.

Par exemple, le module de traitement 190 commande l'écran diffusant 180 en fonction de l'évolution dans le temps des signaux obtenus des deux capteurs capacitifs 120a et 120b lorsque le conducteur ou le passager balaie les zones 600a et 600b selon le sens de la flèche 610.

Par exemple, le module de traitement 190 augmente la température en fonction de l'évolution dans le temps des signaux obtenus des deux capteurs capacitifs 120c et 120d lorsque le conducteur ou le passager balaie les zones 600c et 600d selon le sens de la flèche 630.

Par exemple, le module de traitement 190 réduit la température en fonction de l'évolution dans le temps des signaux obtenus des deux capteurs capacitifs 120c et 120d lorsque le conducteur ou le passager balaie les zones 600c et 600d selon le sens de la flèche 640.

Par exemple, le module de traitement 190 réduit la ventilation en fonction de l'évolution dans le temps des signaux obtenus des trois capteurs capacitifs 120c, 120a et 120d lorsque le conducteur ou le passager balaie les zones 600c, 600a et 600d selon le sens de la flèche 650.

Par exemple, le module de traitement 190 augmente le courant dans la diode électroluminescente en fonction de l'évolution dans le temps des signaux obtenus des trois capteurs capacitifs 120c, 120b et 120d lorsque le conducteur ou le passager balaie les zones 600c, 600b et 600d selon le sens de la flèche 660.

Par exemple, un appui au milieu des capteurs capacitifs 120a à 120d est détecté par le module de traitement 190 qui commande le passage ou non d'un courant dans la diode électroluminescente 100 car les signaux électriques obtenus des capteurs capacitifs sont dans une plage de valeur prédéterminée par exemple comprise entre 20 et 30% du signal provoqué par un appui sur un unique capteur capacitif 120a ou 120b ou 120c ou 120d.

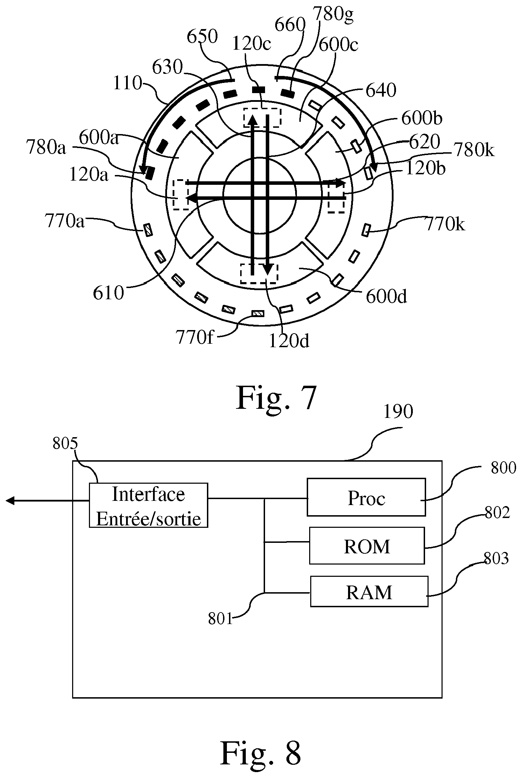

La **Fig. 7** représente un cinquième mode de réalisation du dispositif d'éclairage selon la présente invention.

Le dispositif d'éclairage de la Fig. 7 reprend les différents éléments tels que décrits en référence à la Fig. 6.

Dans la Fig. 7, une pluralité de diodes électroluminescentes 770a à 770k et 780a à 780k est placée en périphérie de la face du circuit imprimé qui n'est pas en regard avec la face collimatrice et le boîtier comporte des réflecteurs optiques pour réfléchir l'énergie lumineuse générée par les diodes électroluminescentes 770a à 770k et 780a à 780k dans la même direction que la diode électroluminescente.

Le module de traitement 190 commande le passage d'un courant dans les diodes électroluminescentes 780a à 780k en fonction du niveau de ventilation.

Le module de traitement 190 commande le passage d'un courant dans les diodes électroluminescentes 770a à 770k en fonction du niveau de température.

Dans l'exemple de la Fig. 7, un courant passe dans les diodes électroluminescentes 770a à 770g et 780a à 780g.

La **Fig. 8** représente un exemple d'architecture du module de traitement selon la présente invention.

Le module de traitement 190 comprend :
- un processeur, micro-processeur, ou microcontrôleur 800 ;
- une mémoire volatile 803 ;
- une mémoire non volatile 802 ;
- une interface entrée sortie 805 ;
- un bus de communication 801 reliant le processeur 800 à la mémoire ROM 803, à la mémoire RAM 803 et à l'interface entrée sortie 805.

Le processeur 800 est capable d'exécuter des instructions chargées dans la mémoire volatile 803 à partir de la mémoire non volatile 802.

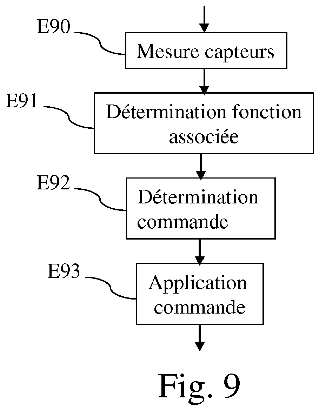

Lorsque le module de traitement 190 est mis sous tension, le processeur 800 est capable de lire de la mémoire volatile 803 des instructions et de les exécuter. Ces instructions forment un programme d'ordinateur qui cause la mise en oeuvre, par le processeur 800, de tout ou partie du procédé décrit en relation avec la Fig. 9.

Tout ou partie du procédé décrit en relation avec la Fig. 9 peut être implémenté sous forme logicielle par exécution d'un ensemble d'instructions par une machine programmable, tel qu'un DSP (*Digital Signal Processor* en anglais ou *Unité de Traitement de Signal Numérique* en français) ou un microcontrôleur ou être implémenté sous forme matérielle par une machine ou un composant dédié, tel qu'un FPGA (*Field-Programmable Gate Array* en anglais ou *Matrice de Portes Programmable sur le Terrain* en français) ou un ASIC (*Application-Specific Integrated Circuit* en anglais ou *Circuit Intégré Spécifique à une Application* en français).

La **Fig. 9** représente un exemple d'algorithme exécuté par le module de traitement selon la présente invention.

La Fig. 9 est décrite dans un exemple ou le présent algorithme est exécuté par le processeur 800.

A l'étape E90, le processeur 800 obtient les signaux électriques du premier et du second capteurs capacitifs 120a et 120b ou des quatre capteurs capacitifs 120a à 120d par l'intermédiaire de l'interface entrée sortie 805.

Si le dispositif d'éclairage permet de commander plusieurs dispositifs, le processeur 800 passe à l'étape E91 et détermine le dispositif qui est associé à une commande en fonction des signaux électriques obtenus des capteurs capacitifs 120a à 120d.

A l'étape E92, le processeur 800 détermine quel type de commande est à appliquer. La commande est une augmentation ou une baisse. La commande est une commande du passage ou non d'un courant dans la diode électroluminescente 100 si les signaux électriques obtenus des capteurs capacitifs sont dans une plage de valeur prédéterminée.

A l'étape E93, le processeur 800 commande par l'interface entrée sortie 805, l'application de la commande déterminée.

## Revendications

1. Dispositif d'éclairage intérieur d'un véhicule constitué d'un boîtier (100) au moins en partie transparent ou translucide dont une des faces transparente ou translucide est un collimateur (130) pour l'énergie lumineuse générée par au moins une diode électroluminescente (100), un premier et un second capteurs capacitifs (120a, 120b) sont placés en regard de ladite face collimatrice, la au moins une diode électroluminescente est placée en regard avec ladite face collimatrice, les capteurs capacitifs sont placés de part et d'autre de la au moins une diode électroluminescente selon une première direction, le dispositif d'éclairage comporte un circuit imprimé (170) comportant un module de traitement (190) qui commande le passage ou non d'un courant dans la au moins une diode électroluminescente si les signaux électriques obtenus du premier et du second capteurs capacitifs sont dans une plage de valeur prédéterminée, **caractérisé en ce que** le module de traitement commande un premier autre dispositif différent du dispositif d'éclairage intérieur en fonction de l'évolution dans le temps des signaux obtenus des deux capteurs capacitifs placés de part et d'autre de la au moins une diode électroluminescente selon la première direction.

2. Dispositif d'éclairage selon la revendication 1, **caractérisé en ce que** si au moins un des signaux électriques obtenus du premier et du second capteurs capacitifs n'est pas dans la plage de valeur prédéterminée, le module de traitement augmente ou réduit le courant dans la au moins une diode électroluminescente.

3. Dispositif selon la revendication 2, **caractérisé en ce que** le module de traitement augmente ou réduit le courant dans la au moins une diode électroluminescente en fonction de l'évolution dans le temps des signaux obtenus des deux capteurs capacitifs placés de part et d'autre de la au moins une diode électroluminescente selon la première direction.

4. Dispositif selon la revendication 1, **caractérisé en ce que** le dispositif d'éclairage comporte un troisième et un quatrième capteurs capacitifs placés de part et d'autre de la au moins une diode électroluminescente selon une seconde direction perpendiculaire à la première direction, et **en ce que** le module de traitement augmente ou réduit le courant dans la au moins une diode électroluminescente en fonction de l'évolution dans le temps des signaux obtenus d'au moins trois capteurs capacitifs.

5. Dispositif selon la revendication 4, **caractérisé en ce que** le module de traitement commande un second autre dispositif différent du dispositif d'éclairage intérieur et du premier autre dispositif en fonction de l'évolution dans le temps des signaux obtenus des deux capteurs capacitifs placés de part et d'autre de la au moins une diode électroluminescente selon la seconde direction.

6. Dispositif selon la revendication 5, **caractérisé en ce que** le premier autre dispositif est un dispositif de régulation de température et le second autre dispositif est un dispositif de ventilation.

7. Dispositif selon l'une quelconque des revendications 1 à 6, **caractérisé en ce qu'**une pluralité d'autres diodes électroluminescentes est placée en périphérie du circuit imprimé et **en ce que** le boîtier comporte des réflecteurs optiques pour réfléchir l'énergie lumineuse générée par les autres diodes électroluminescentes dans la même direction que la au moins une diode électroluminescente.

8. Dispositif selon la revendication 7, **caractérisé en ce que** le module de traitement commande le passage ou non d'un courant dans au moins une diode de la pluralité d'autre diodes en fonction de l'évolution dans le temps des signaux obtenus d'au moins trois capteurs capacitifs ou de deux capteurs capacitifs placés de part et d'autre de la au moins une diode électroluminescente selon la même direction.

9. Procédé de commande d'un dispositif d'éclairage intérieur d'un véhicule constitué d'un boîtier au moins en partie transparent ou translucide dont une des faces transparente ou translucide est un collimateur pour l'énergie lumineuse générée par au moins une diode électroluminescente, **caractérisé en ce que** un premier et un second capteurs capacitifs sont placés en regard avec ladite face collimatrice, la au moins une diode électroluminescente est en regard avec ladite face collimatrice, les capteurs capacitifs sont placés de part et d'autre de la au moins une diode électroluminescente selon une première direction, le dispositif d'éclairage comporte un circuit imprimé comportant un module de traitement, le procédé comporte les étapes de :
- obtention des signaux électriques du premier et du second capteurs capacitifs,
- commande du passage ou non d'un courant dans la au moins une diode électroluminescente si les signaux électriques obtenus du premier et du second capteurs capacitifs sont dans une plage de valeur prédéterminée, **caractérisé en ce que** le module de traitement commande un premier autre dispositif différent du dispositif d'éclairage intérieur en fonction de l'évolution dans le temps des signaux obtenus des deux capteurs capacitifs placés de part et d'autre de la au moins une diode électroluminescente selon la première direction.
